# FASCICULE DE BREVET EUROPEEN

(11) **EP 2 705 733 B1**
(45) Date de publication et mention de la délivrance du brevet: **28.10.2015**
(21) Numéro de dépôt: 12718217.8
(22) Date de dépôt: 02.05.2012
(51) Int. Cl.: H05K 1/02, H02K 11/02

(54) **CIRCUIT IMPRIMÉ DESTINÉ À ASSURER LE RACCORDEMENT D'UN MOTEUR ÉLECTRIQUE ET MOTEUR ÉLECTRIQUE COMPRENANT LE CIRCUIT IMPRIMÉ**
LEITERPLATTE ZUR SICHERSTELLUNG DES ANSCHLUSSES EINES ELEKTROMOTORS UND ELEKTROMOTOR MIT EINER LEITERPLATTE
PRINTED CIRCUIT INTENDED TO ENSURE CONNECTION OF AN ELECTRIC MOTOR AND ELECTRIC MOTOR COMPRISING THE PRINTED CIRCUIT

(30) Priorité: 03.05.2011 FR 1153764
(43) Date de publication de la demande: 12.03.2014
(73) Titulaire: Aldebaran Robotics, 75014 Paris (FR)
(72) Inventeur: CLERC, Vincent, F-92140 Clamart (FR)
(74) Mandataire: Collet, Alain
(86) Numéro de dépôt international: PCT/EP2012/058039
(87) Numéro de publication internationale: WO 2012/150266

(56) Documents cités:
- EP-A1- 1 601 086
- US-A- 5 313 126
- US-A1- 2006 067 070
- US-B1- 6 995 983

## Description

L'invention concerne un moteur électrique et un circuit imprimé destiné à assurer le raccordement électrique du moteur.

L'invention est particulièrement adaptée aux moteurs électriques à balais alimentés en courant continu mais peut tout aussi bien être mise en oeuvre pour tout type de moteur électrique.

Les moteurs à courant continu sont une source de bruit électromagnétique. Des interférences électromagnétiques, bien connues dans la littérature anglo-saxonne sous le nom d'EMI pour « ElectroMagnetic Interference » peuvent être émise par les bornes et les fils d'alimentation du moteur. Ces interférences peuvent perturber d'autres équipements électriques situés à proximité du moteur. Les interférences gênent aussi bien les équipements analogiques que les équipements numériques.

La source la plus importante d'interférence électromagnétique est la commutation des balais du moteur. A chaque commutation, lorsque le balai interrompt son contact avec un segment de collecteur, l'énergie stockée dans le bobinage du moteur sous forme de champ magnétique provoque un pic de tension entre le balai et le segment de collecteur. Cela se produit non seulement pendant la commutation normale, mais aussi dans des situations où les balais rebondissent sur le collecteur tournant. Il est possible d'utiliser des moteurs sans carcasse magnétique sur l'induit, qui génèrent moins de perturbations du fait de la plus faible inductance de l'induit sans toute fois supprimer complètement les perturbations.

Une autre source de perturbation est due aux fils d'alimentation des moteurs. Les perturbations peuvent être conduites ou rayonnées. Pour limiter les perturbations rayonnées, on peut rapprocher au mieux les bornes d'alimentation sur le moteur lui-même et utiliser des fils torsadés pour alimenter le moteur par ses bornes. Malheureusement certains fabricants de moteurs électriques à bas coût proposent des bornes éloignées qui peuvent même être diamétralement opposées. Dans ce cas, même en mettant en oeuvre une paire de fils torsadés, on conserve une boucle de courant au niveau des bornes, boucles ayant tendance à rayonner de l'énergie électromagnétique.

Pour limiter les perturbations conduites, on peut placer au voisinage du moteur des composants de filtrage. Il est courant de disposer des inductances en série sur les fils d'alimentation du moteur et des condensateurs raccordés entre les fils d'alimentation et une masse de l'équipement auquel appartient le moteur. Chacun des condensateurs peut être soudé entre une des bornes du moteur et la carcasse métallique du stator.

Ces composants de filtrage présentent des inconvénients. Ils sont tout d'abord volumineux et augmentent donc l'encombrement de l'équipement. En cas de vibrations subies par l'équipement les composants de filtrage peuvent subir des déplacements différents de ceux du moteur et créer ainsi des contraintes au niveau de leurs raccordements électriques pouvant aller jusqu'à la rupture des raccordements. Le poids des composants de filtrage est également un inconvénient notamment dans des applications embarquées telles que par exemple en robotique humanoïde. En effet, l'augmentation de poids impose une augmentation de couple exercé par les moteurs dans les déplacements du robot entraînant une consommation éclectique plus importante et donc une diminution de l'autonomie du robot.

Ensuite, le filtrage réalisé est loin d'être uniforme en fréquence. De plus, les condensateurs et inductances sont des éléments discrets ajoutés par paires sur chacun des fils d'alimentation. Dans une paire, les valeurs de chaque composant peuvent différer dans leur intervalle de tolérance de fabrication. Ces différences réduisent la qualité du filtrage, notamment pour les perturbations de mode différentiel. Un autre inconvénient réside dans le soudage des condensateurs sur la carcasse du moteur. Dans un moteur électrique à balais alimenté en courant continu, la carcasse statorique accueille des aimants permanents. Ces aimants peuvent être altérés par le soudage qui peut faire monter localement la température de l'aimant au-delà de son point de Curie.

La commande des moteurs est également une source de perturbations électromagnétiques. Cette commande peut se faire selon un découpage haute fréquence du courant continu. Ce type de découpage est bien connu dans la littérature anglo-saxonne sous l'acronyme PWM pour «Pulse With Modulation». Des interrupteurs électroniques hachent le courant continu avec des fronts raides générant de nombreuses harmoniques qui sont à la fois conduites et rayonnées par les fils d'alimentation des moteurs. Ce type de perturbation peut être atténué au moyen des composants de filtrage et aussi au moyen de blindages dans lequel on peut placer le moteur: L'utilisation de paires torsadées est également bénéfique pour limiter ce type de perturbation. Les blindages sont généralement constitués de pièces métalliques rapportées et tendent donc à augmenter le poids, le volume et le coût de l'environnement des moteurs.

Le document US 6 995 983 décrit un filtre utilisé dans un connecteur pour assurer le filtrage de mode commun et le filtrage différentiel. Ce filtre est réalisé à partir d'un circuit imprimé comprenant un plan de masse. Le circuit imprimé est percé pour lasser passer des pins de connecteur et un composant de filtrage est monté en surface du circuit imprimé.

Le document US 5 313 126 décrit la protection d'un moteur électrique à courant continu vis-à-vis d'interférences électromagnétiques au moyen d'un condensateur connecté entre les cosses d'alimentation du moteur. Le condensateur est disposé à l'extérieur du corps cylindrique du moteur.

L'invention vise à limiter les perturbations émises et rayonnées par un moteur électrique en proposant une solution simple à mettre en oeuvre, légère, utilisable pour des moteurs à bas coût et permettant de s'adapter facilement à des moteurs de fournisseurs différents même lorsque les dimensions et les positions de bornes de connexion diffèrent. L'invention permet aussi de limiter la susceptibilité du moteur vis-à-vis de perturbations provenant de son environnement.

A cet effet, l'invention a pour objet un circuit imprimé destiné à être fixé sur un moteur électrique pour en assurer le raccordement électrique, caractérisé en ce qu'il comprend :
- une partie centrale destinée à recouvrir une première face du moteur électrique,
- des languettes souples prolongeant la partie centrale et destinés à recouvrir en partie une seconde face du moteur et à être raccordées électriquement avec cette seconde face,
- une première paire de plots destinés à recevoir des connexions provenant du moteur,
- une seconde paire de plots destinés à recevoir des fils d'alimentation du moteur,
- des pistes raccordant chacune un plot de la première paire avec un plot de la seconde paire,
- un condensateur de filtrage raccordé entre les pistes,
- un plan de masse recouvrant la majeure partie de la partie centrale et les languettes souples, le plan de masse étant destiné à être raccordé électriquement à une pièce métallique formant la seconde face du moteur.

L'invention a également pour objet un moteur électrique comprenant un circuit imprimé selon l'invention.

L'invention sera mieux comprise et d'autres avantages apparaîtront à la lecture de la description détaillée d'un mode de réalisation donné à titre d'exemple, description illustrée par le dessin joint dans lequel :
la figure 1 représente un circuit imprimé conforme à l'invention
les figures 2a, 2a et 2c représentent schématiquement en coupe, des exemples d'empilage de couches formant le circuit imprimé ;
la figure 3 représente schématiquement un condensateur de filtrage pouvant équiper le circuit imprimé ;
les figures 4, 5 et 6 représentent des variantes de condensateurs de filtrage pouvant équiper le circuit imprimé ;
les figures 7a et 7b représentent le circuit imprimé monté sur un moteur électrique.

Par souci de clarté, les mêmes éléments porteront les mêmes repères dans les différentes figures.

La plupart des moteurs électriques rotatifs ont globalement une surface extérieure ayant la forme d'une portion de cylindre limité par deux surfaces planes. L'axe de rotation du moteur est l'axe du cylindre est les connexions du moteur sont réalisées au niveau d'une des deux surfaces planes par des languettes sur lesquelles on vient raccorder des fils d'alimentation par exemple par soudage ou par l'intermédiaire d'un connecteur. Par la suite on englobera sous le terme « fils d'alimentation du moteur » tout moyen de connexion du moteur pour en assurer l'alimentation, comme par exemple un circuit imprimé souple. La portion cylindrique et une des deux surfaces planes peuvent être formées par une enveloppe métallique. La deuxième surface plane peut être réalisée en matière plastique par laquelle sortent les connexions du moteur.

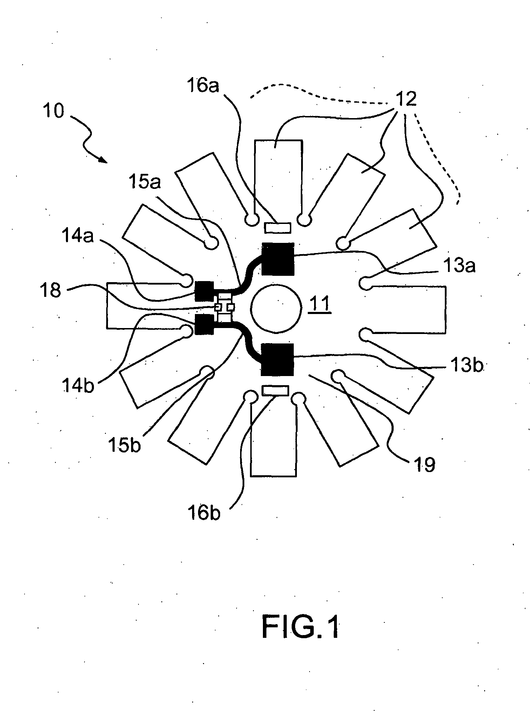

La figure 1 représente un circuit imprimé 10 simple face destiné à être fixé sur un moteur électrique pour en assurer le raccordement électrique. On rappelle qu'un circuit imprimé simple face est formé d'un substrat isolant dont une seule de ses faces reçoit des pistes conductrices. La mise en oeuvre d'un circuit imprimé 10 simple face permet de réduire son coût de réalisation. Le circuit imprimé 10 comprend une partie centrale 11 destinée à recouvrir la surface plane par laquelle sortent les connexions du moteur. Dans l'exemple représenté, la partie centrale 11 est circulaire afin de s'adapter aux moteurs les plus courants. Le diamètre de la partie centrale 11 est sensiblement égal à celui de la surface plane du moteur que la partie centrale 11 doit recouvrir. Il est bien entendu que d'autres formes sont possibles.

Le circuit imprimé 10 comprend en outre des languettes 12 souples prolongeant la partie centrale et destinées à recouvrir en partie la surface cylindrique du moteur. La souplesse des languettes permet de les replier le long de la surface cylindrique. Sur la figure 1, le circuit imprimé 10 est représenté à plat avant repliement des languettes 12, Dans le cas d'une partie centrale 11 circulaire, les languettes 12 s'étendent autour de la partie centrale 11 selon des rayons de la partie centrale 11 lorsque le circuit imprimé 10 est à plat. Sur la figure 1, douze languettes 12 sont uniformément réparties autour de la partie, centrale 11. Il est bien entendu que l'invention n'est pas limitée à ce nombre de languettes.

Le circuit imprimé 10 comprend également une première paire de plots 13a et 13b destinés à recevoir des connexions provenant du moteur et une seconde paire de plots 14a et 14b destinés à recevoir des fils d'alimentation du moteur. Une piste 15a raccorde les plots 13a et 14a. Une piste 15b raccorde les plots 13b et 14b.

On peut prévoir deux trous 16a et 16b traversant le circuit imprimé 10 et destinés à laisser passer des cosses de connexion du moteur. Le trou 16a est réalisé au voisinage du plot 13a et le trou 16b est réalisé au voisinage du plot 13b.

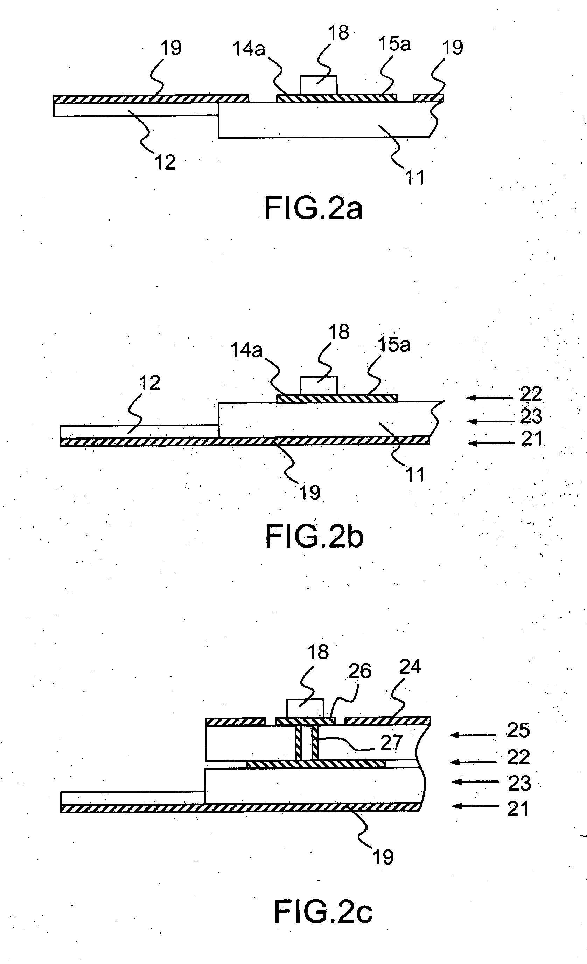

Un condensateur de filtrage 18 est raccordé entre les pistes 15a et 15b. Un plan de masse 19 recouvre la majeure partie de la partie centrale 11 et les languettes souples 12. Dans le cas d'un circuit imprimé simple face, comme représenté en coupe sur la figure 2a, le plan de masse 19 est détouré pour laisser place aux plots 13a, 13b, 14a, 14b et aux pistes 15a et 15b.

Il est également possible de réaliser un circuit imprimé double face comme représenté en coupe sur la figure 2b. Le plan de masse 19 est réalisé sur une face externe du circuit imprimé 10 et les plots et les pistes sont réalisés sur la face externe opposée. Autrement dit, le circuit imprimé 10 comprend deux couches conductrices 21 et 22 séparées par une couche isolante 23. La couche 21 forme le plan de masse 19. Les pistes 15a et 15b et les deux paires de plots 13a, 13b, 14a, 14b sont gravées dans la couche 22. Lors du montage du circuit imprimé 10 sur un moteur électrique, le plan de masse 19 est destiné à faire face à la surface du moteur électrique recouverte par le circuit imprimé 10. Ainsi, le plan de masse 19 fait écran entre le moteur et les pistes 15a et 15b afin de mieux les protéger contre des perturbations rayonnées par le moteur.

On peut encore améliorer la protection des pistes 15a et 15b en ajoutant un second plan de masse 24, comme représenté en coupe sur la figure 2c. Les pistes 15a et 15b sont alors encadrées entre les deux plans de masse 19 et 24. Autrement dit, le circuit imprimé 10 comprend une troisième couche conductrice formant le second plan de masse 24, une couche isolante 25 étant disposée entre les couches conductrices 22 et 24. Le plan de masse 24 est détouré pour laisser place à des plages 26 permettant de recevoir le condensateur 18. Les plages 26 sont raccordées aux pistes 15a. et 15b au moyen de trous métallisés 27.

Avantageusement le condensateur 18 est de type X2Y et est raccordé aux pistes 15a et 15b ainsi qu'au plan de masse 19. Ce type de condensateur est fabriqué par la société Johanson Dielectrics situé 15191 Bledsoe St. Sylmar, California aux Etats-Unis d'Amérique. Une documentation complète de ce type de condensateur peut être consultée sur le site www.x2y.com.

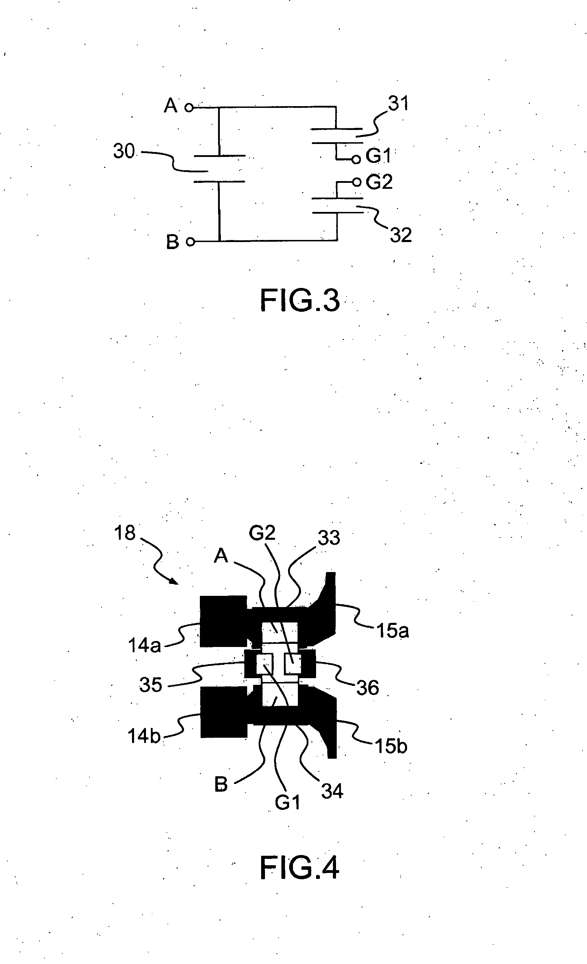

La figure 3 présente un schéma équivalent d'un condensateur de type X2Y. Ce composant comprend quatre bornes de raccordement A, B, G1 et G2. Un condensateur élémentaire principal 30 est raccordé entre les bornes A et B et deux condensateurs élémentaires auxiliaires 31 et 32 sont raccordés entre la borne A et la borne G1 pour le condensateur 31 et entre la borne B et la borne G2 pour le condensateur 32. Pour sa réalisation, les électrodes des différents condensateurs 30, 31 et 32 sont entrelacées et l'ensemble est encapsulé dans un boitier destiné à être monté en surface d'un circuit imprimé sans traversée. Les deux condensateurs auxiliaires 31 et 32 sont parfaitement appariés.

La figure 4 représente le condensateur 18 de type X2Y monté sur le circuit imprimé 10 de telle sorte que les bornes A et B soient raccordées chacune à une des pistes 15a et 15b et que les bornes G1 et G2 soient raccordées au plan de masse 19. L'utilisation des trois condensateurs élémentaires 30, 31 et 32 permet de limiter aussi bien les perturbations de mode commun que les perturbations différentielles. L'imbrication des différents condensateurs élémentaires 30, 31 et 32 permet de compenser le rayonnement émis par chacune des pistes 15a et 15b. Le condensateur 18 de type X2Y est par exemple réalisé dans un boitier destiné à être monté en surface du circuit imprimé 10. A cet effet la piste 15a comprend une plage 33 permettant d'accueillir la borne A, la piste 15b comprend une plage 34 permettant d'accueillir la borne B et le plan de masse 19 comprend deux plages 35 et 36 permettant d'accueillir les bornes G1 et G2. Les différentes bornes du condensateur 18 sont brasées sur leur plage respective.

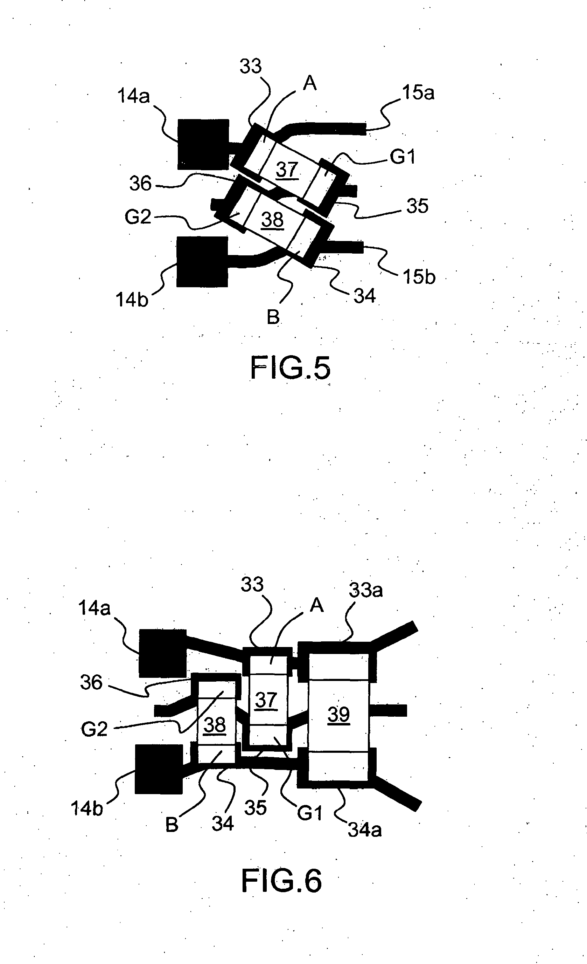

Alternativement, le condensateur de filtrage est formé par deux condensateurs 37 et 38 raccordés en série entre les pistes 15a, 15b. Le plan de masse 19 est alors raccordé aux bornes communes des deux condensateurs 37 et 38. Les deux condensateurs 37 et 38 sont discrets et de même valeur. Pour bien comprendre la similitude électrique avec là figure 4, on a conservé le nom des bornes A et G1 pour le condensateur 37 et le nom des bornes B et G2 pour le condensateur 38. Il est alors souhaitable de rapprocher au plus près les deux condensateurs discrets 37 et 38 comme représenté sur la figure 5, de façon à générer une inductance mutuelle la plus importante possible entre les deux condensateurs discrets 37 et 38. Plus précisément on rapproche au plus près les bornes A et G2 d'une part et les bornes B et G1 d'autre part. Cette disposition permet de réduire le rayonnement émis et la susceptibilité au rayonnement extérieur des deux pistes 15a et 15b. Comme dans l'alternative mettant en oeuvre un condensateur de type X2Y, les condensateurs 37 et 38 peuvent être réalisés dans un boitier destiné à être monté en surface du circuit imprimé 10. A cet effet, on retrouve sur la figure 4 les plages 33 à 36. Cette alternative apporte néanmoins de moins bons résultats en termes de filtrage de perturbations électromagnétiques qu'avec un condensateur de type X2Y. Avec les deux condensateurs discrets, on ne filtre que les perturbations de mode commun des deux pistes 15a et 15b par rapport à la masse.

En utilisant des condensateurs discrets, il est possible d'améliorer encore le filtrage en ajoutant un troisième condensateur 39 raccordé entre les pistes 15a et 15b, comme représenté sur la figure 6. Le condensateur 39 est électriquement équivalent au condensateur élémentaire 30 du condensateur de type X2Y. Le condensateur 39 permet de filtrer les perturbations de mode différentielle entre les deux pistes 15a et 15b. Le condensateur 39 peut être réalisé dans un boitier destiné à être monté en surface du circuit imprimé 10. A cet effet le condensateur 39 est brasé entre une plage 33a appartenant à la piste 15a et une plage 33b appartenant à la piste 15b. Comme précédemment, il est avantageux de rapprocher au plus près les trois condensateurs discrets 37 38 et 39 comme représenté sur la figure 6, de façon à générer une inductance mutuelle la plus importante possible entre eux.

On n'atteint tout de même pas la performance du condensateur de type X2Y dont les électrodes sont entrelacées, ce qui permet de maximiser l'inductance mutuelle des différents condensateurs élémentaires 30, 31 et 32 qui le compose. De plus, les condensateurs élémentaires 31 et 32 sont mieux appariés que lorsqu'on met en oeuvre des condensateurs discrets 37 et 38. Autrement dit, un condensateur de type X2Y filtre mieux les perturbations de mode commun que les deux condensateurs discrets 37 et 38.

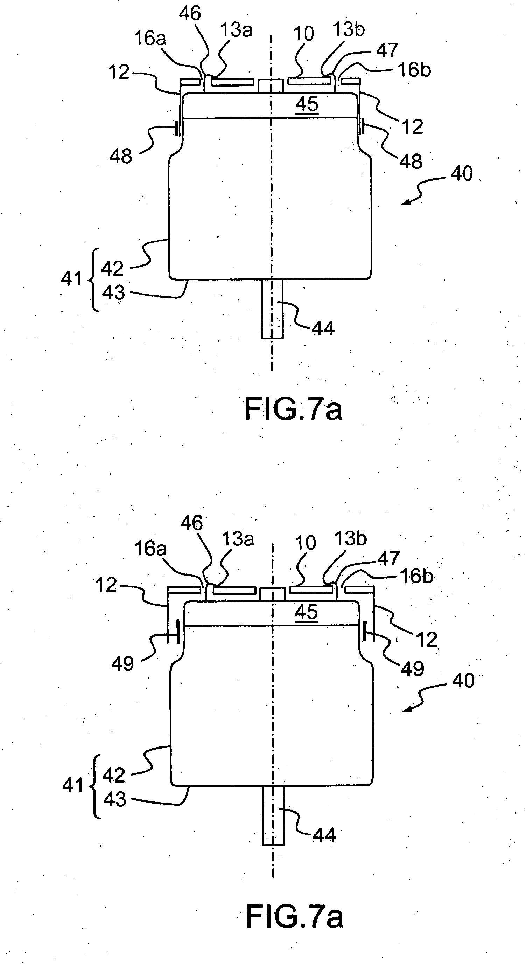

Les figures 7a et 7b représentent un moteur électrique 40 équipé du circuit imprimé 10. Le moteur 40 comprend une enveloppe métallique 41 ayant la forme d'une surface cylindrique 42 et d'un fond plan 43. Un arbre de sortie 44 du moteur s'étend le long de l'axe de la surface cylindrique 42 et sort du moteur 40 par le fond 43. Le moteur 40 est fermé par un capot plastique 45 formant une surface plane circulaire parallèle au fond 43. Deux cosses 46 et 47 sortent du capot 45 et forment les bornes d'alimentation du moteur 40. Le circuit imprimé 10 est disposé contre le capot 45. Plus précisément, la partie centrale 11 est placée parallèlement à la surface plane formée par le capot 45. Chacune des cosses 46 et 47 traverse un des trous 16a et 16b du circuit imprimé 10 puis est repliée parallèlement à la partie centrale 11 pour être raccordé sur chacun des plots respectifs 13a et 13b, par exemple par soudage.

Les languettes 12 sont repliées le long de la surface cylindrique 42 perpendiculairement au plan de la partie centrale 11 de façon à ce que le plan de masse 19 puisse entrer en contact électrique avec l'enveloppe métallique 41 au niveau de la surface cylindrique 42. On obtient ainsi un raccordement électrique des bornes G1 et G2 du condensateur 18 à l'enveloppe métallique 41.

Le fait d'utiliser des languettes 12 souples permet la mise en place du circuit imprimé 10 sur des moteurs dont le diamètre de la surface cylindrique peut légèrement varier. On pourra par exemple dans une fabrication en série mettre en oeuvre des moteurs électriques provenant de fabricants différents.

De plus, toujours dans l'éventualité de fabricants différents, on peut prévoir plusieurs paires de trous 16a et 16b, si les différents fabricants retenus proposent des cosses situés à des endroits différents du capot 45.

Le raccordement électrique du plan de masse 19 au niveau des languettes 12 et de l'enveloppe métallique 41 au niveau de la surface cylindrique 42 peut se faire par contact direct comme représenté sur la figure 7a. Les languettes 12 peuvent être maintenues pressées contre l'enveloppe métallique 41 au moyen d'un ruban adhésif 48 entourant les languettes 12. Alternativement, comme représenté sur la figure 7b, il est possible d'assurer ce raccordement en interposant un adhésif conducteur double face 49 adhérant d'une part sur la surface cylindrique 42 et d'autre part sur les languettes 12.

## Revendications

1. Circuit imprimé destiné à être fixé sur un moteur électrique (40) pour en assurer le raccordement électrique, comprenant:
• une partie centrale (11) destinée à recouvrir une première face (45) du moteur électrique (40),
• des languettes souples (12) prolongeant la partie centrale (11) et destinées à recouvrir en partie une seconde face (42) du moteur (40) et à être raccordées électriquement avec cette seconde face (42),
• une première paire de plots (13a, 13b) destinés à recevoir des connexions (46, 47) provenant du moteur (40),
• une seconde paire de plots (14a, 14b) destinés à recevoir des fils d'alimentation du moteur (40),
• des pistes (15a, 15b) raccordant chacune un plot de la première paire (13a, 13b) avec un plot de la seconde paire (14a, 14b),
• un condensateur de filtrage (18 ; 37, 38, 39) raccordé entre les pistes (15a, 15b),
• un plan de masse (19) recouvrant la majeure partie de la partie centrale (11) et les languettes souples (12), le plan de masse (19) étant destiné à être raccordé électriquement à une pièce métallique formant la seconde face (42) du moteur (40).

2. Circuit imprimé selon la revendication 1, **caractérisé en ce que** le condensateur (18) est de type X2Y et est raccordé aux pistes (15a, 15b) et au plan de masse (19).

3. Circuit imprimé selon la revendication 1, **caractérisé en ce que** le condensateur de filtrage est formé par deux condensateurs (37, 38) discrets raccordés en série entre les pistes (15a, 15b) et **en ce que** le plan de masse (19) est raccordé à des bornes communes (G1, G2) des deux condensateurs (37, 38).

4. Circuit imprimé selon la revendication 3, **caractérisé en ce qu'**il comprend en outre un troisième condensateur discret (39) raccordé entre les pistes (15a, 15b).

5. Circuit imprimé selon l'une quelconque des revendications 3 ou 4, **caractérisé en ce que** les condensateurs (37, 38, 39) discrets sont disposés au plus près les uns des autres de façon à générer une inductance mutuelle la plus importante possible entre eux.

6. Circuit imprimé selon l'une des revendications précédentes, **caractérisé en ce que** la partie centrale (11) est circulaire et **en ce que** les languettes (12) s'étendent autour de la partie centrale (11) selon des rayons de la partie centrale (11) lorsque le circuit imprimé (10) est à plat.

7. Circuit imprimé selon l'une des revendications précédentes, **caractérisé en ce qu'**il est simple face.

8. Circuit imprimé selon l'une des revendications précédentes, **caractérisé en ce qu'**il comprend deux couches conductrices (21, 22) séparées par une couche isolante (23), **en ce que** qu'une première (21) des deux couches conductrices forme le plan de masse (19), **en ce que** les pistes (15a, 15b) et les deux paires de plots (13a, 13b, 14a, 14b) sont gravées dans la seconde (22) des deux couches conductrices et **en ce que** le plan de masse (19) est destiné à faire face à la première face (45) du moteur électrique (40).

9. Circuit imprimé selon la revendication 8, **caractérisé en ce que** la seconde couche conductrice (22) est disposé entre la première couche conductrice (21) et une troisième couche conductrice (24) formant un second plan de masse, une seconde couche isolante (25) étant disposée entre la seconde (22) et la troisième (25) couche conductrice.

10. Moteur électrique, **caractérisé en ce qu'**il comprend un circuit imprimé (10) selon l'une des revendications précédentes.

11. Moteur électrique selon la revendication 10, **caractérisé en ce que** le raccordement électrique du plan de masse (19) au niveau des languettes (12) et de la seconde face (42) du moteur (40) se fait par contact direct et **en ce que** les languettes (12) sont maintenues pressées contre la seconde face (42) au moyen d'un ruban adhésif (48) entourant les languettes (12).

12. Moteur électrique selon la revendication 11, **caractérisé en ce que** le raccordement électrique du plan de masse (19) au niveau des languettes (12) et de la seconde face (42) du moteur (40) est assuré en interposant un adhésif conducteur double face (49) adhérant d'une part sur la seconde face (42) et d'autre part sur les languettes (12).

## Patentansprüche

1. Leiterplatte zur Befestigung an einem Elektromotor (40) zwecks Sicherstellung seines elektrischen Anschlusses, umfassend:
einen zentralen Teil (11), der bestimmt ist, eine erste Seite (45) des Elektromotors (40) zu bedecken,
elastische Zungen (12), die den zentralen Teil (11) verlängern und bestimmt sind, eine zweite Fläche (42) des Motors (40) teilweise zu bedecken und elektrisch mit dieser zweiten Fläche (42) verbunden zu sein,
ein erstes Paar Kontakte (13a, 13b), die bestimmt sind, Anschlüsse (46, 47) vom Motor (40) zu empfangen,
ein zweites Paar Kontakte (14a, 14b), die bestimmt sind, Versorgungsdrähte des Motors (40) zu empfangen,
Bahnen (15a, 15b), die jeweils einen Kontakt des ersten Paars (13a, 13b) mit einem Kontakt des zweiten Paars (14a, 14b) verbinden,
einen zwischen den Bahnen (15a, 15b) angeschlossenen Filterkondensator (18; 37, 38, 39),
eine Grundplatte (19), die den größten Teil des zentralen Teils (11) und die elastischen Zungen (12) bedeckt, wobei die Grundplatte (19) bestimmt ist, elektrisch mit einem Metallteil, das die zweite Fläche (42) des Motors (40) bildet, verbunden zu sein.

2. Leiterplatte nach Anspruch 1, **dadurch gekennzeichnet, dass** der Kondensator (18) vom Typ X2Y ist und mit den Bahnen (15a, 15b) und mit der Grundplatte (19) verbunden ist.

3. Leiterplatte nach Anspruch 1, **dadurch gekennzeichnet, dass** der Filterkondensator von zwei diskreten Kondensatoren (37, 38) gebildet ist, die zwischen den Bahnen (15a, 15b) in Reihe verbunden sind und dass die Grundplatte (19) mit gemeinsamen Klemmen (G1, G2) der zwei Kondensatoren (37, 38) verbunden ist.

4. Leiterplatte nach Anspruch 3, **dadurch gekennzeichnet, dass** sie ferner einen dritten diskreten Kondensator (39) umfasst, der zwischen den Bahnen (15a, 15b) verbunden ist.

5. Leiterplatte nach einem der Ansprüche 3 oder 4, **dadurch gekennzeichnet, dass** die diskreten Kondensatoren (37, 38, 39) so nah wie möglich beieinander angeordnet sind, um zwischen sich eine gegenseitige Induktanz zu erzeugen, die so groß wie möglich ist.

6. Leiterplatte nach einem der vorangehenden Ansprüche, **dadurch gekennzeichnet, dass** der zentrale Teil (11) kreisföimig ist und dass sich die Zungen (12) um den zentralen Teil (11) gemäß den Radien des zentralen Teils (11) erstrecken, wenn die Leiterplatte (10) flach ist.

7. Leiterplatte nach einem der vorangehenden Ansprüche, **dadurch gekennzeichnet, dass** sie einflächig ist.

8. Leiterplatte nach einem der vorangehenden Ansprüche, **dadurch gekennzeichnet, dass** sie zwei leitende Schichten (21, 22) umfasst, die von einer Isolierschicht (23) getrennt sind, dass eine erste (21) der zwei leitenden Schichten die Grundplatte (19) bildet, dass die Bahnen (15a, 15b) und die zwei Paare Kontakte (13a, 13b, 14a, 14b) in die zweite (22) der zwei leitenden Schichten graviert sind und dass die Grundplatte (19) bestimmt ist, der ersten Fläche (45) des Elektromotors (40) gegenüberzuliegen.

9. Leiterplatte nach Anspruch 8, **dadurch gekennzeichnet, dass** die zweite leitende Schicht (22) zwischen der ersten leitenden Schicht (21) und einer dritten leitenden Schicht (24), die eine zweite Grundplatte bildet, angeordnet ist, wobei eine zweite Isolierschicht (25) zwischen der zweiten (22) und der dritten (25) leitenden Schicht angeordnet ist.

10. Elektromotor, **dadurch gekennzeichnet, dass** er eine Leiterplatte (10) nach einem der vorangehenden Ansprüche umfasst.

11. Elektromotor nach Anspruch 10, **dadurch gekennzeichnet, dass** die elektrische Verbindung der Grundplatte (19) im Bereich der Zungen (12) und der zweiten Fläche (42) des Motors (40) durch direkten Kontakt erfolgt und dass die Zungen (12) mittels eines Haftbands (48), das die Zungen (12) umschließt, gegen die zweite Fläche (42) gepresst gehalten werden.

12. Elektromotor nach Anspruch 11, **dadurch gekennzeichnet, dass** die elektrische Verbindung der Grundplatte (19) im Bereich der Zungen (12) und der zweiten Fläche (42) des Motors (40) durch Zwischenstellen eines doppelseitigen leitenden Haftbands (49) sichergestellt ist, das einerseits auf der zweiten Fläche (42) und andererseits auf den Zungen (12) haftet.

## Claims

1. A printed circuit intended to be fixed to an electric motor (40) to ensure its electrical connection, comprising:
a central part (11) intended to cover a first face (45) of the electric motor (40),
flexible tongues (12) extending the central part (11) and intended to partly cover a second face (42) of the motor (40) and to be electrically connected to this second face (42),
a first pair of studs (13a, 13b) intended to receive connections (46, 47) from the motor (40),
a second pair of studs (14a, 14b) intended to receive power supply wires of the motor (40),
tracks (15a, 15b) each connecting a stud of the first pair (13a, 13b) to a stud of the second pair (14a, 14b),
a filtering capacitor (18; 37, 38, 39) connected between the tracks (15a, 15b),
a ground plane (19) covering most of the central part (11) and the flexible tongues (12), the ground plane (19) being intended to be electrically connected to a metal part forming the second face (42) of the motor (40).

2. The printed circuit as claimed in claim 1, **characterized in that** the capacitor (18) is of X2Y type and is connected to the tracks (15a, 15b) and to the ground plane (19).

3. The printed circuit as claimed in claim 1, **characterized in that** the filtering capacitor is formed by two discrete capacitors (37, 38) connected in series between the tracks (15a, 15b) and **in that** the ground plane (19) is connected to common terminals (G1, G2) of the two capacitors (37, 38).

4. The printed circuit as claimed in claim 3, **characterized in that** it also comprises a third discrete capacitor (39) connected between the tracks (15a, 15b).

5. The printed circuit as claimed in any one of claims 3 or 4, **characterized in that** the discrete capacitors (37, 38, 39) are arranged as close as possible to one another so as to generate a mutual inductance that is as great as possible between them.

6. The printed circuit as claimed in any of the preceding claims, **characterized in that** the central part (11) is circular and **in that** the tongues (12) extend around the central part (11) according to radii from the central part (11) when the printed circuit (10) is flat.

7. The printed circuit as claimed in any of the preceding claims, **characterized in that** it is single-sided.

8. The printed circuit as claimed in any of the preceding claims, **characterized in that** it comprises two conductive layers (21, 22) separated by an insulating layer (23), **in that** a first (21) of the two conductive layers forms the ground plane (19), **in that** the tracks (15a, 15b) and the two pairs of studs (13a, 13b, 14a, 14b) are etched in the second (22) of the two conductive layers and **in that** the ground plane (19) is intended to face the first face (45) of the electric motor (40).

9. The printed circuit as claimed in claim 8, **characterized in that** the second conductive layer (22) is arranged between the first conductive layer (21) and a third conductive layer (24) forming a second ground plane, a second insulating layer (25) being arranged between the second (22) and the third (25) conductive layers.

10. An electric motor, **characterized in that** it comprises a printed circuit (10) as claimed in any of the preceding claims.

11. The electric motor as claimed in claim 10, **characterized in that** the electrical connection of the ground plane (19) on the tongues (12) and the second face (42) of the motor (40) is made by direct contact and **in that** the tongues (12) are kept pressed against the second face (42) by means of an adhesive tape (48) surrounding the tongues (12).

12. The electric motor as claimed in claim 11, **characterized in that** the electrical connection of the ground plane (19) on the tongues (12) and on the second face (42) of the motor (40) is ensured by interposing a double-sided conductive adhesive (49) adhering on the one hand to the second face (42) and on the other hand to the tongues (12).
